(19) Europäisches Patentamt
European Patent Office
Office européen des brevets

(11) **EP 4 279 992 A1**

(12) **EUROPEAN PATENT APPLICATION**

(43) Date of publication:
**22.11.2023 Bulletin 2023/47**

(21) Application number: **22174095.4**

(22) Date of filing: **18.05.2022**

(51) International Patent Classification (IPC):
**G03F 7/20** $^{(2006.01)}$     **G06Q 10/00** $^{(2023.01)}$

(52) Cooperative Patent Classification (CPC):
**G03F 7/70975; G03F 7/70533; G06Q 10/0639;
G06Q 10/20; G06Q 50/04**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(71) Applicant: **ASML Netherlands B.V.
5500 AH Veldhoven (NL)**

(72) Inventors:
• **COLLIGNON, Tijmen, Pieter
5500 AH Veldhoven (NL)**
• **HAUPTMANN, Marc
5500 AH Veldhoven (NL)**

(74) Representative: **ASML Netherlands B.V.
Corporate Intellectual Property
P.O. Box 324
5500 AH Veldhoven (NL)**

(54) **METHOD OF OPTIMIZING MAINTENANCE OF A LITHOGRAPHIC APPARATUS**

(57)     Disclosed is a method of optimizing maintenance of a lithographic apparatus. The method comprises obtaining productivity data relating to a productivity of a lithographic apparatus and error metric data relating to the effect of a maintenance action on exposure performance. The productivity data and error metric data is used to determine such that a loss of productivity metric is reduced or minimized, one or both of: a number of layers to ramp down in production of integrated circuits prior to the maintenance action on the lithographic apparatus, said layers being lithographically exposed on each of a plurality of substrates using the lithographic apparatus; and/or a maintenance schedule metric relating to the frequency of performance of said maintenance action.

Fig. 4

**Description**

FIELD OF THE INVENTION

The present invention relates to methods and apparatus usable, for example, in the manufacture of devices by lithographic techniques, and to methods of manufacturing devices using lithographic techniques.

BACKGROUND ART

A lithographic apparatus is a machine that applies a desired pattern onto a substrate, usually onto a target portion of the substrate. A lithographic apparatus can be used, for example, in the manufacture of integrated circuits (ICs). In that instance, a patterning device, which is alternatively referred to as a mask or a reticle, may be used to generate a circuit pattern to be formed on an individual layer of the IC. This pattern can be transferred onto a target portion (e.g. including part of a die, one die, or several dies) on a substrate (e.g., a silicon wafer). Transfer of the pattern is typically via imaging onto a layer of radiation-sensitive material (resist) provided on the substrate. In general, a single substrate will contain a network of adjacent target portions that are successively patterned. These target portions are commonly referred to as "fields".

In the manufacture of complex devices, typically many lithographic patterning steps are performed, thereby forming functional features in successive layers on the substrate. A critical aspect of performance of the lithographic apparatus is therefore the ability to place the applied pattern correctly and accurately in relation to features laid down (by the same apparatus or a different lithographic apparatus) in previous layers. For this purpose, the substrate is provided with one or more sets of alignment marks. Each mark is a structure whose position can be measured at a later time using a position sensor, typically an optical position sensor. The lithographic apparatus includes one or more alignment sensors by which positions of marks on a substrate can be measured accurately. Different types of marks and different types of alignment sensors are known from different manufacturers and different products of the same manufacturer.

In other applications, metrology sensors are used for measuring exposed structures on a substrate (either in resist and/or after etch). A fast and non-invasive form of specialized inspection tool is a scatterometer in which a beam of radiation is directed onto a target on the surface of the substrate and properties of the scattered or reflected beam are measured. Examples of known scatterometers include angle-resolved scatterometers of the type described in US2006033921A1 and US2010201963A1. In addition to measurement of feature shapes by reconstruction, diffraction based overlay can be measured using such apparatus, as described in published patent application US2006066855A1. Diffraction-based overlay metrology using dark-field imaging of the diffraction orders enables overlay measurements on smaller targets. Examples of dark field imaging metrology can be found in international patent applications WO 2009/078708 and WO 2009/106279 which documents are hereby incorporated by reference in their entirety. Further developments of the technique have been described in published patent publications US20110027704A, US20110043791A, US2011102753A1, US20120044470A, US20120123581A, US20130258310A, US20130271740A and WO2013178422A1. These targets can be smaller than the illumination spot and may be surrounded by product structures on a wafer. Multiple gratings can be measured in one image, using a composite grating target. The contents of all these applications are also incorporated herein by reference.

It is necessary to routinely perform maintenance actions on a lithographic so as to replace deteriorated components. It may be necessary to ramp-down (temporarily cease production) of one or more layers in the run-up to a maintenance action, as the fingerprints or impact of the replacement component compared to replaced component can cause large overlay errors when different layers of the same substrate have been exposed before and after the maintenance action.

It is desirable to mitigate the effect of these maintenance actions on productivity.

SUMMARY OF THE INVENTION

The invention in a first aspect provides a method of optimizing maintenance of a lithographic apparatus, the method comprising: obtaining productivity data relating to a productivity of a lithographic apparatus; obtaining error metric data relating to the effect of a maintenance action on exposure performance; and using said productivity data and error metric data to determine, such that a loss of productivity metric is reduced, one or both of: a number of layers to ramp down in production of integrated circuits prior to the maintenance action on the lithographic apparatus, said layers being lithographically exposed on each of a plurality of substrates using the lithographic apparatus; and/or a maintenance schedule metric relating to the frequency of performance of said maintenance action.

The invention in a second aspect provides a method of determining a maintenance schedule metric relating to the scheduling of a maintenance action on a lithographic apparatus, the method comprising: obtaining lithographic apparatus monitoring data; obtaining layer cycle time data related to the time required to ramp down production of a plurality of layers lithographically exposed on each of a plurality of substrates using the lithographic apparatus; using a conversion model to convert said lithographic apparatus monitoring data into error metric data; determining a non-correctable component of the error metric data using an actuation model for the lithographic apparatus; and determining said maintenance schedule metric based on a performance criterion, said layer cycle time data and said non-correctable component of the error metric

Also disclosed is a computer program and lithographic apparatus being operable to perform the method of the first aspect or second aspect.

The above and other aspects of the invention will be understood from a consideration of the examples described below.

BRIEF DESCRIPTION OF THE DRAWINGS

Embodiments of the invention will now be described, by way of example only, with reference to the accompanying drawings, in which:

Figure 1 depicts a lithographic apparatus;
Figure 2 illustrates schematically measurement and exposure processes in the apparatus of Figure 1;
Figure 3(a) conceptually illustrates the cancelling effect in overlay of wafer table fingerprints in each layer in the absence of a wafer table swap, and Figure 3(b) conceptually illustrates the performance impact in overlay of such a wafer table swap;
Figure 4 is a plot of cumulative lots of wafers produced against time, illustrating the concept of C-time;
Figure 5(a) and (b) each shows a plot of cumulative lots of wafers produced against time for two different maintenance action strategies;
Figure 6 is a plot of C-time against number of layers ramped down, illustrating an embodiment of the invention;
Figure 7 is a flowchart describing a method for scheduling maintenance actions according to an embodiment; and
Figure 8 is a flowchart of a refinement of the method of Figure 7.

DETAILED DESCRIPTION OF EMBODIMENTS

Before describing embodiments of the invention in detail, it is instructive to present an example environment in which embodiments of the present invention may be implemented.

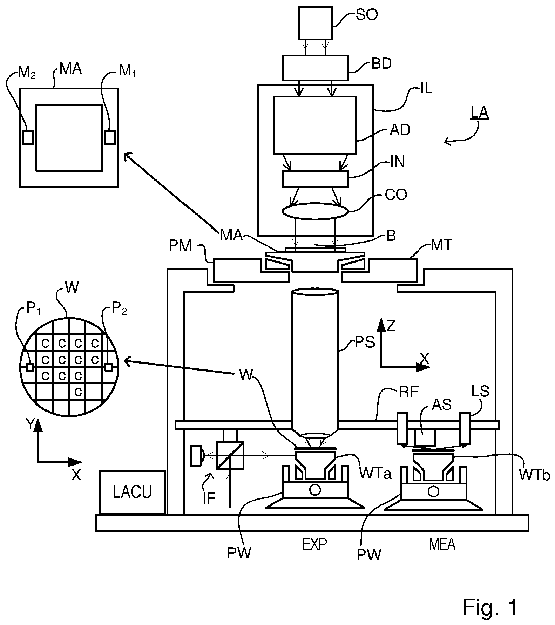

Figure 1 schematically depicts a lithographic apparatus LA. The apparatus includes an illumination system (illuminator) IL configured to condition a radiation beam B (e.g., UV radiation or DUV radiation), a patterning device support or support structure (e.g., a mask table) MT constructed to support a patterning device (e.g., a mask) MA and connected to a first positioner PM configured to accurately position the patterning device in accordance with certain parameters; two substrate tables (e.g., a wafer table) WTa and WTb each constructed to hold a substrate (e.g., a resist coated wafer) W and each connected to a second positioner PW configured to accurately position the substrate in accordance with certain parameters; and a projection system (e.g., a refractive projection lens system) PS configured to project a pattern imparted to the radiation beam B by patterning device MA onto a target portion C (e.g., including one or more dies) of the substrate W. A reference frame RF connects the various components, and serves as a reference for setting and measuring positions of the patterning device and substrate and of features on them.

The illumination system may include various types of optical components, such as refractive, reflective, magnetic, electromagnetic, electrostatic or other types of optical components, or any combination thereof, for directing, shaping, or controlling radiation.

The patterning device support MT holds the patterning device in a manner that depends on the orientation of the patterning device, the design of the lithographic apparatus, and other conditions, such as for example whether or not the patterning device is held in a vacuum environment. The patterning device support can use mechanical, vacuum, electrostatic or other clamping techniques to hold the patterning device. The patterning device support MT may be a frame or a table, for example, which may be fixed or movable as required. The patterning device support may ensure that the patterning device is at a desired position, for example with respect to the projection system.

The term "patterning device" used herein should be broadly interpreted as referring to any device that can be used to impart a radiation beam with a pattern in its cross-section such as to create a pattern in a target portion of the substrate. It should be noted that the pattern imparted to the radiation beam may not exactly correspond to the desired pattern in the target portion of the substrate, for example if the pattern includes phase-shifting features or so called assist features. Generally, the pattern imparted to the radiation beam will correspond to a particular functional layer in a device being created in the target portion, such as an integrated circuit.

As here depicted, the apparatus is of a transmissive type (e.g., employing a transmissive patterning device).

Alternatively, the apparatus may be of a reflective type (e.g., employing a programmable mirror array of a type as referred to above, or employing a reflective mask). Examples of patterning devices include masks, programmable mirror arrays, and programmable LCD panels. Any use of the terms "reticle" or "mask" herein may be considered synonymous with the more general term "patterning device." The term "patterning device" can also be interpreted as referring to a device storing in digital form pattern information for use in controlling such a programmable patterning device.

The term "projection system" used herein should be broadly interpreted as encompassing any type of projection system, including refractive, reflective, catadioptric, magnetic, electromagnetic and electrostatic optical systems, or any combination thereof, as appropriate for the exposure radiation being used, or for other factors such as the use of an immersion liquid or the use of a vacuum. Any use of the term "projection lens" herein may be considered as synonymous with the more general term "projection system".

The lithographic apparatus may also be of a type wherein at least a portion of the substrate may be covered by a liquid having a relatively high refractive index, e.g., water, so as to fill a space between the projection system and the substrate. An immersion liquid may also be applied to other spaces in the lithographic apparatus, for example, between the mask and the projection system. Immersion techniques are well known in the art for increasing the numerical aperture of projection systems.

In operation, the illuminator IL receives a radiation beam from a radiation source SO. The source and the lithographic apparatus may be separate entities, for example when the source is an excimer laser. In such cases, the source is not considered to form part of the lithographic apparatus and the radiation beam is passed from the source SO to the illuminator IL with the aid of a beam delivery system BD including, for example, suitable directing mirrors and/or a beam expander. In other cases the source may be an integral part of the lithographic apparatus, for example when the source is a mercury lamp. The source SO and the illuminator IL, together with the beam delivery system BD if required, may be referred to as a radiation system.

The illuminator IL may for example include an adjuster AD for adjusting the angular intensity distribution of the radiation beam, an integrator IN and a condenser CO. The illuminator may be used to condition the radiation beam, to have a desired uniformity and intensity distribution in its cross section.

The radiation beam B is incident on the patterning device MA, which is held on the patterning device support MT, and is patterned by the patterning device. Having traversed the patterning device (e.g., mask) MA, the radiation beam B passes through the projection system PS, which focuses the beam onto a target portion C of the substrate W. With the aid of the second positioner PW and position sensor IF (e.g., an interferometric device, linear encoder, 2-D encoder or capacitive sensor), the substrate table WTa or WTb can be moved accurately, e.g., so as to position different target portions C in the path of the radiation beam B. Similarly, the first positioner PM and another position sensor (which is not explicitly depicted in Figure 1) can be used to accurately position the patterning device (e.g., mask) MA with respect to the path of the radiation beam B, e.g., after mechanical retrieval from a mask library, or during a scan.

Patterning device (e.g., mask) MA and substrate W may be aligned using mask alignment marks M1, M2 and substrate alignment marks PI, P2. Although the substrate alignment marks as illustrated occupy dedicated target portions, they may be located in spaces between target portions (these are known as scribe-lane alignment marks). Similarly, in situations in which more than one die is provided on the patterning device (e.g., mask) MA, the mask alignment marks may be located between the dies. Small alignment marks may also be included within dies, in amongst the device features, in which case it is desirable that the markers be as small as possible and not require any different imaging or process conditions than adjacent features. The alignment system, which detects the alignment markers is described further below.

The depicted apparatus could be used in a variety of modes. In a scan mode, the patterning device support (e.g., mask table) MT and the substrate table WT are scanned synchronously while a pattern imparted to the radiation beam is projected onto a target portion C (i.e., a single dynamic exposure). The speed and direction of the substrate table WT relative to the patterning device support (e.g., mask table) MT may be determined by the (de-)magnification and image reversal characteristics of the projection system PS. In scan mode, the maximum size of the exposure field limits the width (in the non-scanning direction) of the target portion in a single dynamic exposure, whereas the length of the scanning motion determines the height (in the scanning direction) of the target portion. Other types of lithographic apparatus and modes of operation are possible, as is well-known in the art. For example, a step mode is known. In so-called "maskless" lithography, a programmable patterning device is held stationary but with a changing pattern, and the substrate table WT is moved or scanned.

Combinations and/or variations on the above described modes of use or entirely different modes of use may also be employed.

Lithographic apparatus LA is of a so-called dual stage type which has two substrate tables WTa, WTb and two stations - an exposure station EXP and a measurement station MEA - between which the substrate tables can be exchanged. While one substrate on one substrate table is being exposed at the exposure station, another substrate can be loaded onto the other substrate table at the measurement station and various preparatory steps carried out. This enables a substantial increase in the throughput of the apparatus. The preparatory steps may include mapping the surface height contours of the substrate using a level sensor LS and measuring the position of alignment markers on the substrate using an alignment sensor AS. If the position sensor IF is not capable of measuring the position of the substrate table while it is at the measurement station as well as at the exposure station, a second position sensor may be provided to enable the positions of the substrate table to be tracked at both stations, relative to reference frame RF. Other arrangements are known and usable instead of the dual-stage arrangement shown. For example, other lithographic apparatuses are known in which a substrate table and a measurement table are provided. These are docked together when performing preparatory measurements, and then undocked while the substrate table undergoes exposure.

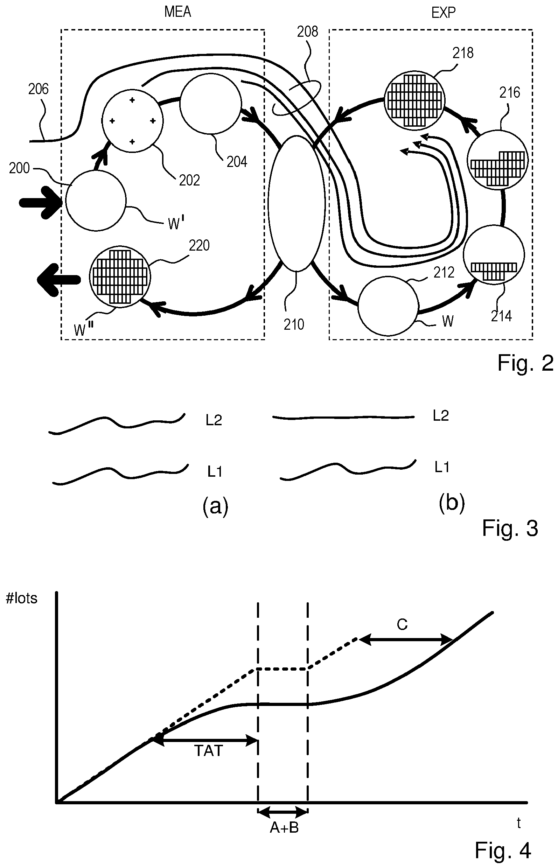

Figure 2 illustrates the steps to expose target portions (e.g. dies) on a substrate W in the dual stage apparatus of Figure 1. On the left hand side within a dotted box are steps performed at a measurement station MEA, while the right hand side shows steps performed at the exposure station EXP. From time to time, one of the substrate tables WTa, WTb will be at the exposure station, while the other is at the measurement station, as described above. For the purposes of this description, it is assumed that a substrate W has already been loaded into the exposure station. At step 200, a new substrate W' is loaded to the apparatus by a mechanism not shown. These two substrates are processed in parallel in order to increase the throughput of the lithographic apparatus.

Referring initially to the newly-loaded substrate W', this may be a previously unprocessed substrate, prepared with a new photo resist for first time exposure in the apparatus. In general, however, the lithography process described will be merely one step in a series of exposure and processing steps, so that substrate W' has been through this apparatus and/or other lithography apparatuses, several times already, and may have subsequent processes to undergo as well. Particularly for the problem of improving overlay performance, the task is to ensure that new patterns are applied in exactly the correct position on a substrate that has already been subjected to one or more cycles of patterning and processing. These processing steps progressively introduce distortions in the substrate that must be measured and corrected for, to achieve satisfactory overlay performance.

The previous and/or subsequent patterning step may be performed in other lithography apparatuses, as just mentioned, and may even be performed in different types of lithography apparatus. For example, some layers in the device manufacturing process which are very demanding in parameters such as resolution and overlay may be performed in a more advanced lithography tool than other layers that are less demanding. Therefore some layers may be exposed in an immersion type lithography tool, while others are exposed in a 'dry' tool. Some layers may be exposed in a tool working at DUV wavelengths, while others are exposed using EUV wavelength radiation.

At 202, alignment measurements using the substrate marks PI etc. and image sensors (not shown) are used to measure and record alignment of the substrate relative to substrate table WTa/WTb. In addition, several alignment marks across the substrate W' will be measured using alignment sensor AS. These measurements are used in one embodiment to establish a "wafer grid", which maps very accurately the distribution of marks across the substrate, including any distortion relative to a nominal rectangular grid.

At step 204, a map of wafer height (Z) against X-Y position is measured also using the level sensor LS. Conventionally, the height map is used only to achieve accurate focusing of the exposed pattern. It may be used for other purposes in addition.

When substrate W' was loaded, recipe data 206 were received, defining the exposures to be performed, and also properties of the wafer and the patterns previously made and to be made upon it. To these recipe data are added the measurements of wafer position, wafer grid and height map that were made at 202, 204, so that a complete set of recipe and measurement data 208 can be passed to the exposure station EXP. The measurements of alignment data for example comprise X and Y positions of alignment targets formed in a fixed or nominally fixed relationship to the product patterns that are the product of the lithographic process. These alignment data, taken just before exposure, are used to generate an alignment model with parameters that fit the model to the data. These parameters and the alignment model will be used during the exposure operation to correct positions of patterns applied in the current lithographic step. The model in use interpolates positional deviations between the measured positions. A conventional alignment model might comprise four, five or six parameters, together defining translation, rotation and scaling of the 'ideal' grid, in different dimensions. Advanced models are known that use more parameters.

At 210, wafers W' and W are swapped, so that the measured substrate W' becomes the substrate W entering the exposure station EXP. In the example apparatus of Figure 1, this swapping is performed by exchanging the supports WTa and WTb within the apparatus, so that the substrates W, W' remain accurately clamped and positioned on those supports, to preserve relative alignment between the substrate tables and substrates themselves. Accordingly, once the tables have been swapped, determining the relative position between projection system PS and substrate table WTb (formerly WTa) is all that is necessary to make use of the measurement information 202, 204 for the substrate W (formerly W') in control of the exposure steps. At step 212, reticle alignment is performed using the mask alignment marks M1, M2. In steps 214, 216, 218, scanning motions and radiation pulses are applied at successive target locations across the substrate W, in order to complete the exposure of a number of patterns.

By using the alignment data and height map obtained at the measuring station in the performance of the exposure steps, these patterns are accurately aligned with respect to the desired locations, and, in particular, with respect to features previously laid down on the same substrate. The exposed substrate, now labeled W" is unloaded from the apparatus at step 220, to undergo etching or other processes, in accordance with the exposed pattern.

The skilled person will know that the above description is a simplified overview of a number of very detailed steps involved in one example of a real manufacturing situation. For example rather than measuring alignment in a single pass, often there will be separate phases of coarse and fine measurement, using the same or different marks. The coarse and/or fine alignment measurement steps can be performed before or after the height measurement, or interleaved.

A lithographic apparatus or scanner requires regular maintenance actions, for example to replace hardware components which are subject to degradation over time. By way of a specific example, the wafer table of a scanner degrades and requires periodic replacement. Such hardware swaps and/or maintenance actions, can result in a performance impact.

Such a performance impact is conceptually illustrated in Figure 3. Overlay is an important parameter which describes the proper placement of a layer with respect to a previously exposed (lower) layer. Each wafer table imposes a wafer clamping impact or clamping fingerprint on a substrate clamped thereto, which should be corrected for. However, as a wafer table wears over time, the associated wafer clamping impact is affected (typically becoming greater) which will affect the positioning of exposed structures on the substrate. As such, the degradation of the wafer table (and other components) will lead to positional errors; these errors can be divided into lower frequency errors or correctable errors (CEs), which may be measured (using a suitable metrology tool) and corrected for within the scanner via a process correction loop (e.g., as known as the advanced process corrections or APC loop), and higher frequency errors or noncorrectable errors (NCEs) which cannot be corrected via APC either because the effect of the errors cannot be measured using sufficiently fast metrology, captured by the models used to represent the metrology data and/or because the required corrections cannot be actuated within the scanner.

Without a wafer table swap, the wafer clamping impact changes sufficiently slowly such that there is essentially no significant change between exposures of different layers on a single wafer. Because overlay is a relative measure between two layers, NCEs resulting from this impact in each layer largely cancel themselves out. Referring to Figure 3(a), the lines for the first layer L1 and second layer L2 represent a high frequency component of wafer grid impact of a degraded wafer table. Although this degradation results in a relatively large magnitude disturbance of the local placement of features in each exposure layer, these disturbances are typically sufficiently similar in each layer and cancel themselves out in overlay (i.e., the positional errors are the same in each layer meaning that misalignment between layers due to this effect is relatively small). Therefore, overlay NCEs due to this wafer table fingerprint in each layer will be small. By contrast, Figure 3(b) conceptually illustrates the situation should there be a wafer table swap between exposure of layer L1 and L2. The new table results in an overall smaller wafer grid impact due to wafer table imperfection; however the impact of the old table is present in the layer L1 exposure. Therefore, there is no longer a cancelling out of this impact, resulting in a significantly larger NCE overlay penalty. This may cause an APC non-correctable jump due to the difference in these fingerprints, which may be sufficiently large to affect yield (the fact that the errors are non-correctable means that these wafers cannot be recovered via rework).

This overlay penalty due to hardware maintenance during wafer processing (i.e., between exposing different layers on a wafer) is often referred to as a wafer-in-process (WIP) impact. One strategy to mitigate this WIP impact, is to "ramp-down" the exposure of a number of layers in the run-up to such a maintenance action, so as to reduce the number of wafers in progress (wafers with only some of the required layers exposed) at the time of the action. Such a ramp-down typically comprises the ceasing of exposure of one or more layers in the weeks leading up to the maintenance action, e.g., ceasing exposure of each layer in turn from the bottom layer, at intervals of a few days to a couple or few weeks between the ramping down of each successive layer. It may be that not all layers are ramped down, and optimizing the number of layers which are to be ramped down is an aim of at least some of the methods disclosed herein. This ramping down of layers represents a loss of productivity with respect to continuing wafer production at the rate prior to beginning ramp-down.

In addition to a ramp-down impact, there will be an accompanying ramp-up impact (i.e., in comparison to full production rate) when production restarts following the maintenance action. For example, there is a need to restart production for each layer ramped down before production of layers higher in the stack can be started. In addition, the correction loop or APC loop needs to be restarted as there is no (or insufficient) metrology data for the post-maintenance system. Because of this, many of the first wafers in progress that are exposed post-maintenance action will be exposed out-of-spec and therefore will require reworking (stripped of the exposed resist, re-covered and re-exposed).

The combination of this ramp-down and ramp-up time leads to what is often referred to as C-time: the time impact of these ramp-down and ramp-up periods with respect to no ramp-up or ramp-down. C-time is additional to A-time (the nominal downtime for the actual maintenance action) and B-time (a margin applied to the A-time).

Figure 4 is a plot of the cumulative number of lots #lots against time showing production rate for a production period (solid line) which includes a ramp-down period, maintenance action and ramp-up period. The A+B time is the period of the actual maintenance action including margin, during which productivity is nil (machine down-time). The dotted line represents a nominal production rate had there been no ramp-down or ramp-up time, and production continued at a constant rate till the maintenance action and again immediately on recommencing production after the action. C-time is the time difference between the two plots after completion of ramp-up and production has reached an approximately steady rate. It may be appreciated that C-time is typically much greater than A+B-time, more so than illustrated in this plot.

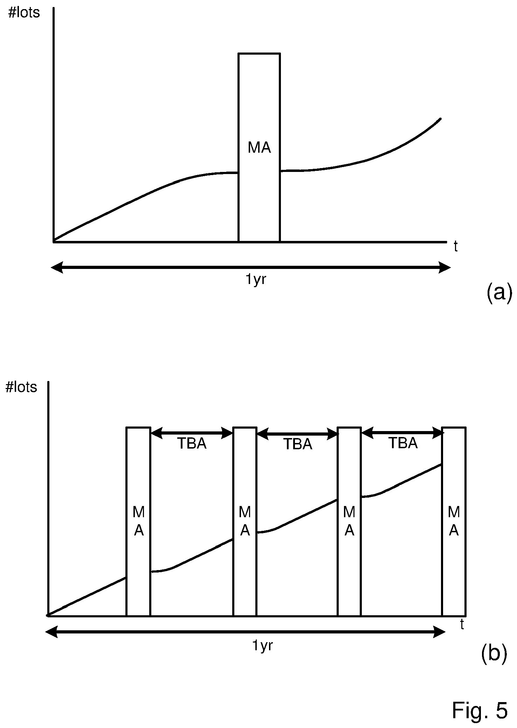

There are a number of different approaches and strategies for handling maintenance actions. Two extremes will now be described which are illustrated by Figures 5(a) and 5(b); both of these extremes are known to be used presently. Other present strategies include strategies between the two extremes.

Figure 5(a) is a plot of the cumulative number of lots #lots against time showing production rate for a first extreme strategy. Such a strategy may cluster several interventions together and only perform maintenance actions MA at a rate determined by the anticipated maximum lifetime (e.g., about 2 years) of the weakest part (e.g., wafer table). Such a method will typically require a complete ramp-down of all critical layers over an extended ramp-down period, as the now highly deteriorated wafer table (and possibly other components) will impart a very different wafer grid fingerprint compared to its replacement. This scenario is limited by cycle time of the fab (e.g., the total turnaround time TAT, which determines the ramp down speed (and therefore the ramp up speed).

Figure 5(b) is an equivalent plot for a strategy at the other extreme, where maintenance actions MA are performed relatively often (e.g., multiple times a year), with no layer ramp-down at all. Ramp-up time will also be smaller, and not limited by fab cycle time. However, this strategy will result in a large number of WIP lots to finish up (and for which specific APC threads will need reset), and in parallel a large number of new lots for which APC requires restarting.

Neither of these extremes is likely to be optimal (e.g., result in a minimized C-time). As such, a method is proposed which optimizes or determines the level of ramp down and/or maintenance action scheduling, in order to find an optimized (e.g., minimized or reduced) amount of C-time. Such an approach may be based on an optimization/determination of a C-time (or related metric) cost-function. More specifically, the proposed method may optimize or determine the number of layers to ramp down and/or maintenance action scheduling such that loss of productivity (e.g., according to a loss of productivity metric such as C-time or lost wafers/lots per day) is minimized or reduced. Depending on the use case, this can mean that either ramp-down time or ramp-up time dominates. In an embodiment, the optimization may comprise a co-optimization of the number of layers to ramp down and the time between maintenance actions/maintenance action frequency (e.g., a maintenance action frequency metric). Alternatively, the time between maintenance actions may be fixed and the number of layers to ramp down optimized for a given maintenance action schedule. In another alternative, the number of layers to ramp down may be calculated based on an error metric, and the time between maintenance actions optimized.

The input parameters for the cost function may comprise:

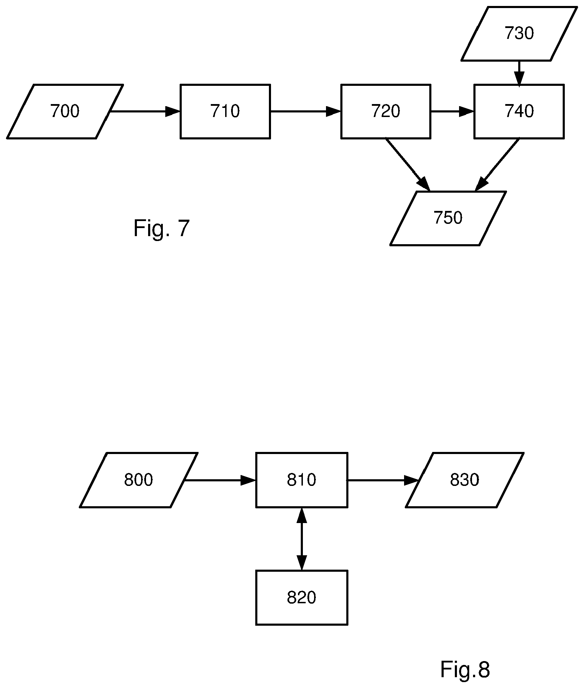

- layer cycle time data related to the time required to ramp down production of a layer. This may be an average over all layers (e.g., the total turnaround time or ramp-down time divided by the number of layers), or else may comprise a respective layer cycle times for each layer (in reality, each layer will have a different associated ramp-down or cycle time);
- a baseline throughput parameter or baseline rate parameter relating to a baseline production rate (e.g., in terms of wafers or lots per day) prior to any ramp-down. The layer cycle time and baseline rate parameter may be collectively referred to as productivity data.
- an error metric such as a correctable error metric describing (or being a proxy for) an expected APC correctable process jump (or more generally a process jump of change in error metric which is correctable via the process control loop used in the lithographic process) for each layer $\Delta CE$ and/or a non-correctable error metric describing (or being a proxy for) an expected APC non-correctable process jump (or more generally a process jump of change in error metric which is not correctable via the process control loop used in the lithographic process) for each layer $\Delta NCE$. Either of these error metrics may be determined from experience from previous interventions and/or predicted/modeled based on scanner metrology, such as levelling data due to wafer table root cause, lens measurements due to lens root cause. This scanner data can be measured and translated into an overlay impact caused by process drift due to component deterioration, which will be removed when the deteriorated component is replaced, resulting in a process jump. This correctable and/or non-correctable process jump can be determined per layer. A novel method for determining this (correctable and/or non-correctable) error metric will be described in combination with Figure 7 below.
- a maintenance schedule metric, such as a time between maintenance actions (e.g., hardware component replacement). Alternatively this parameter may be optimized for in combination with optimizing for the number of layers to ramp down.

Much of this data is measurable or may be obtained from scanner data (either present or historical) or a virtual computing platform. When not optimized, the maintenance schedule metric may be user chosen.

As such, the objective function may be constructed as a function of the input parameters listed above and a metric describing the number of layers to be ramped down. The cost of this function (e.g., the loss of productivity metric) may be minimized in terms of finding the optimal number of layers to ramp down, and optionally also in terms of finding the optimal time between maintenance actions. The loss of productivity metric may comprise C-time or related metrics such as wafers per day (WPD) lost or critical wafers per day lost. Critical wafers per day refers to the wafer exposure on layers that are e.g., overlay critical, and hence need to be "purged" in order to avoid yield deterioration due to WIP impact. What is commonly observed is that these layers are ramped down, with the "freed" scanner capacity used to expose lower spec layers, such that total scanner output remains stable. Therefore the loss of productivity metric may manifest as a critical WPD reduction prior/after a hardware swap, with total WPD remaining the same.

A purely exemplary cost function may calculate a cost $WPD_C$ in terms of lost wafers per day or critical wafers per day as:

$$WPD_C = WPD_{BL} \times \frac{\left(\frac{TAT}{\#layers} \times \#layers_{rd}\right)}{TBA} \times 2 + \frac{\#layers_{reset} \times \#wafers_{rw}}{TBA}$$

where: $WPD_{BL}$ is the baseline production rate prior to ramp-down (e.g., as described by the dotted line on Figure 4), $TAT$ is the turnaround time or total ramp-down time (see Figure 4), $\#layers$ is the total number of layers, $\#layers_{rd}$ is the number of layers ramped down, $TBA$ is the time between maintenance actions (see Figure 5(b)), $\#layers_{reset}$ is the number of layers requiring an APC loop reset, where $\#layers_{reset} = \Sigma_i \theta_1(\Delta CE_i, CE_T)$, $\Delta CE_i$ is the expected APC correctable jump for layer $i$, and $\#wafers_{rw}$ is the number of wafers which require reworking for each layer. The APC loop only requires reset if the APC correctable jump is larger than a correctable error threshold value $CE_T$ (e.g., between 0.1nm and 0.5nm, between 0.2nm and 0.4nm or between 0.25nm and 0.35nm). This will determine how many rework iterations per layer is required for APC reset. As such, $\theta_1(\Delta CE_i, CE_T)$ is a function such as a step function or Heaviside function (i.e., 0 below the correctable error threshold $CE_T$, and 1 equal and above the correctable error threshold $CE_T$).

It can be appreciated that the first term largely relates to ramp-down and the second term largely relates to ramp-up. The factor 2 of the first term allows for the fact that a ramp-down will also require a corresponding ramp-up.

As has already been described, the cost $WPD_C$ may be minimized in terms of optimizing the number of layers to be ramped down $\#layers_{rd}$, or minimized to co-optimize the number of layers to be ramped down $\#layers_{rd}$ and the time between maintenance actions $TBA$.

In an alternative embodiment, the cost $WPD_C$ may be minimized in terms of optimizing the time between maintenance actions $TBA$. In such an embodiment, the number of layers to be ramped down $\#layers_{rd}$ may be determined based on an error metric, more specifically a non-correctable error metric. In such a method, the number of layers to ramp down may be determined as all those which are calculated to cause a jump in non-correctable error (e.g., not correctable via the APC loops) which is a above a non-correctable error threshold indicative of an acceptable magnitude of non-correctable error. Therefore, the number of layers to ramp down may be determined as $\#layers_{rd} = \Sigma_i \theta_2(\Delta NCE_i, NCE_T)$, where $\Delta NCE_i$ is the expected APC non-correctable jump for layer $i$, and $\theta_2(\Delta NCE_i, NCE_T)$ is a function such as a step function or Heaviside function (i.e., 0 below the non-correctable error threshold $NCE_T$, and 1 equal and above the non-correctable error threshold $NCE_T$).

As such, the proposed method may be used to make a decision on the optimal moment to swap, in terms of C-time and/or to minimize C-time by balancing gain vs cost of C-time ramp-up and/or ramp-down solutions.

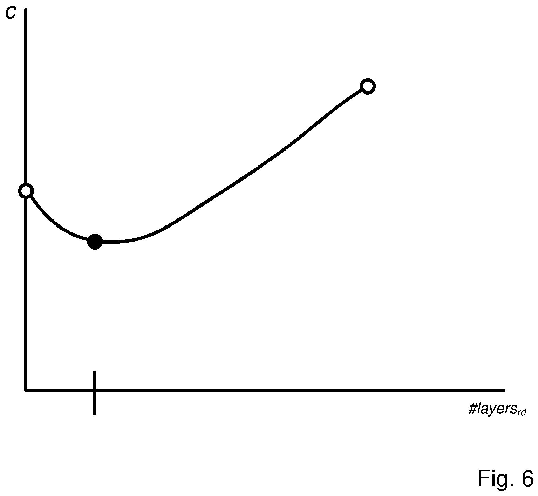

Figure 6 is an exemplary plot of C-time against number of layers ramped down $\#layers_{rd}$. The two white points plotted relate to the extreme strategies described, i.e., frequent maintenance actions with zero layers ramped down and maximized time between maintenance actions with all layers ramped down. It can be seen that neither of these strategies is optimal in minimizing C-time. The minimum C time is found at a point (black point) between these two extremes and which can be determined using the methods disclosed herein. Ramp-up time dominates for lower numbers of layers ramped down from this C-time minimum point, and ramp-down time dominates for higher numbers of layers ramped down from this point.

Figure 7 is a flowchart illustrating an alternative embodiment for making maintenance action decisions based on a C-time prediction. Such a method proposes predicting non-correctable WIP impacts based on inline monitoring mechanisms (scanner monitoring data 700) such as e.g. wafer table qualification data, levelling data, lens model drift data, etc.. This scanner monitoring data 700 can be translated 710 into an overlay (or other parameter of interest) impact using suitable models such as physical conversion models (e.g., a 'Z2XY' model which determines distortion induced overlay from leveling data and aberration sensitivities (which can be calculated using lithographical simulations)).

In a next step, the non-correctable error portion of the overlay impact is calculated 720 using an actuation model for the scanner. This step may comprise combining this non-correctable impact into a breakdown of the node overlay performance in order to predict the total overlay impact under realistic process control performance assumptions. Node overlay performance can be assessed using regular production data for multiple lots collected across different layers before and after the maintenance action. This data can be used to assess the on-product variability and its improvement due to the maintenance action (e.g., new scanner hardware). Since regular production data is used, it does not contain any WIP impact. The data can then be combined with the expected WIP impact determined based on scanner data, e.g. Z2XY data. This may be achieved by means of a root-mean-square determination in terms of overlay impact or by combining the on-product variability fingerprints with the WIP impact fingerprint and then using a dies-in-spec statistical approach to determine potential yield impact.

Based on a current per layer performance criterion (e.g. overlay spec) and the amount and total turnaround time or ramp down time of the layers 730, the resulting productivity / C-time impact can be calculated 740. Based on the amount and total-turnaround time of the layers that would end up out-of-spec, a decision 750 as to whether a maintenance action should be performed, may be made.

Such a method allows direct prediction of improvements over the status quo. For example, in the case of wafer table swaps, the WIP and C-time impact can be predicted by converting levelling data into predicted overlay data via gradient based calculations (Z2XY).

It can be appreciated that the non-correctable error metric of the previous embodiment may be determined by performing steps 700, 710 and 720 of this embodiment. Similarly, it can be appreciated that the correctable error metric of the previous embodiment may be determined by performing steps 700 and 710, followed by a variation of step 720 where the correctable error portion of the overlay impact is calculated (rather than the NCE portion).

Figure 8 is a flowchart illustrating an extension of the methodology described by Figure 7. Historical scanner monitoring data 800 (e.g., of the same type as scanner monitoring data 700) may be fed into a machine learning model 810 (e.g., a recurrent neural network such as a long short-term memory LSTM model) to predict overlay and/or NCE data 820 (e.g., equivalent to the outputs of step 710 and/or 720 of the previous embodiment). This predicted overlay and/or NCE data 820 may be used along with the historical scanner monitoring data 800 to forecast 830 the 'trend' of the hardware deterioration, and/or to predict the NCE / C-time impact at a given point in time in the future.

This forecasting of the future 'trend' of deterioration and C-time impact enables optimal scheduling of maintenance actions which requires partial ramp down of layers due to the expected WIP / non-correctable impact. Such an optimal schedule may balance ramp down, ramp up and APC resets to minimize WPD impact.

While specific embodiments of the invention have been described above, it will be appreciated that the invention may be practiced otherwise than as described.

Further embodiments of the invention are disclosed in the list of numbered clauses below:

1. A method of optimizing maintenance of a lithographic apparatus, the method comprising:

obtaining productivity data relating to a productivity of a lithographic apparatus;
obtaining error metric data relating to the effect of a maintenance action on exposure performance;
and using said productivity data and error metric data to determine, such that a loss of productivity metric is reduced, one or both of: a number of layers to ramp down in production of integrated circuits prior to the maintenance action on the lithographic apparatus, said layers being lithographically exposed on each of a plurality of substrates using the lithographic apparatus; and/or a maintenance schedule metric relating to the frequency of performance of said maintenance action.

2. A method according to clause 1, wherein said productivity data comprises:
layer cycle time data related to the time required to ramp down production of each layer; and baseline rate parameter data relating to a baseline production rate.

3. A method according to clause 2, wherein said layer cycle time data comprises an average layer cycle time value for each layer.

4. A method according to clause 2, wherein said layer cycle time data comprises a respective layer cycle time value for each layer.

5. A method according to any of clauses 2 to 4, wherein the loss of productivity metric comprises a number of substrates lost with respect to said baseline production rate, number of critical substrates lost with respect to said baseline production rate and/or time lost due to said ramp-down and corresponding ramp-up compared to said baseline production rate.

6. A method according to any preceding clause wherein said determining step comprises optimizing a cost function relating the loss of productivity metric to said number of layers to ramp down, productivity data, maintenance schedule metric and error metric data.

7. A method according to clause 6, wherein the cost function comprises a ramp-down term describing the effect of ramping down layers prior to said maintenance action on said loss of productivity metric and a ramp up-term describing the effect of ramping up layers subsequent to said maintenance action on said loss of productivity metric.

8. A method according to any preceding clause comprising obtaining lithographic apparatus monitoring data; and determining said error metric data from said lithographic apparatus monitoring data.

9. A method according to any preceding clause wherein the error metric data is used to determine a number of layers for which a correction loop requires resetting subsequent to said maintenance action.

10. A method according to clause 9, wherein the error metric data comprises correctable error metric data comprising a correctable component of said error metric data.

11. A method according to clause 10, comprising determining the number of layers for which a correction loop requires resetting as all layers which are calculated to cause a jump in said correctable error component which is a above a correctable error threshold indicative of an acceptable magnitude of correctable error.

12. A method according to clause 10 or 11, comprising: obtaining lithographic apparatus monitoring data; using a conversion model to convert said lithographic apparatus monitoring data into error metric data; and determining a correctable component of the error metric data using an actuation model for the lithographic apparatus.

13. A method according to any of clauses 9 to 12, wherein said determining step comprises combining said determined number of layers for which a correction loop requires resetting with a number of substrates which require rework due to the effect of the maintenance action.

14. A method according to any preceding clause, wherein said determining step optimizes the number of layers to ramp down, and further uses a chosen maintenance schedule metric relating to the frequency of performance of said maintenance action.

15. A method according to any of clauses 1 to 13, wherein said determining step optimizes the maintenance schedule metric, and the number of layers to be ramped down is determined based on the error metric data.

16. A method according to clause 15, wherein said error metric data comprises non-correctable error metric data comprising a non-correctable component of said error metric data.

17. A method according to clause 16, comprising determining the number of layers to ramp down as all layers which are calculated to cause a jump in said non-correctable error component which is a above a non-correctable error threshold indicative of an acceptable magnitude of non-correctable error.

18. A method according to clause 16 or 17, comprising: obtaining lithographic apparatus monitoring data; using a conversion model to convert said lithographic apparatus monitoring data into error metric data; and determining a non-correctable component of the error metric data using an actuation model for the lithographic apparatus.

19. A method according to any of clauses 1 to 13, wherein said determining step comprises cooptimizing said number of layers to ramp down and the maintenance schedule metric.

20. A method according to clause 14 or 19, further comprising performing said ramp-down according to the optimized number of layers to ramp-down.

21. A method according to any of clauses 15 to 19, further comprising performing said maintenance action according to the optimized maintenance schedule metric.

22. A method according to any preceding clause, wherein said correctable error metric relates to an overlay error.

23. A method according to any preceding clause, wherein said the step of determining such that a loss of productivity metric is reduced comprises determining such that a loss of productivity metric is minimized.

24. A method of determining a maintenance schedule metric relating to the scheduling of a maintenance action on a lithographic apparatus, the method comprising: obtaining lithographic apparatus monitoring data; obtaining layer cycle time data related to the time required to ramp down production of a plurality of layers lithographically exposed on each of a plurality of substrates using the lithographic apparatus; using a conversion model to convert said lithographic apparatus monitoring data into error metric data; determining a non-correctable component of the error metric data using an actuation model for the lithographic apparatus; determining said maintenance schedule metric based on a performance criterion, said layer cycle time data and said non-correctable component of the error metric.

25. A method according to clause 24, wherein said lithographic apparatus monitoring data comprises historical lithographic apparatus monitoring data and said conversion model comprises a machine learning model; and said method further comprises: predicting using said model, one or both of: a future trend of deterioration of a hardware component of said lithographic apparatus, said maintenance action being related to said hardware component and/or a future trend of a loss of productivity metric and/or the non-correctable component of the error metric.

26. A computer program comprising program instructions operable to perform the method of any of clauses 1 to 25, when run on a suitable apparatus.

27. A non-transient computer program carrier comprising the computer program of clause 26.

28. A processing system comprising a processor and a storage device comprising the computer program of clause 26.

29. A lithographic apparatus comprising the processing system of clause 28.

30. A lithographic apparatus according to clause 29, further comprising: a patterning device support for supporting a patterning device; projection optics for projecting a pattern onto the patterning device; and a substrate support for supporting a substrate.

Although specific reference may have been made above to the use of embodiments of the invention in the context of optical lithography, it will be appreciated that the invention may be used in other applications, for example imprint lithography, and where the context allows, is not limited to optical lithography. In imprint lithography a topography in a patterning device defines the pattern created on a substrate. The topography of the patterning device may be pressed into a layer of resist supplied to the substrate whereupon the resist is cured by applying electromagnetic radiation, heat, pressure or a combination thereof. The patterning device is moved out of the resist leaving a pattern in it after the resist is cured.

The terms "radiation" and "beam" used herein encompass all types of electromagnetic radiation, including ultraviolet (UV) radiation (e.g., having a wavelength of or about 365, 355, 248, 193, 157 or 126 nm) and extreme ultraviolet (EUV) radiation (e.g., having a wavelength in the range of 1-100 nm), as well as particle beams, such as ion beams or electron beams.

The term "lens", where the context allows, may refer to any one or combination of various types of optical components, including refractive, reflective, magnetic, electromagnetic and electrostatic optical components. Reflective components are likely to be used in an apparatus operating in the UV and/or EUV ranges.

The breadth and scope of the present invention should not be limited by any of the above-described exemplary embodiments, but should be defined only in accordance with the following claims and their equivalents.

## Claims

1. A method of optimizing maintenance of a lithographic apparatus, the method comprising:

   obtaining productivity data relating to a productivity of a lithographic apparatus;
   obtaining error metric data relating to the effect of a maintenance action on exposure performance; and
   using said productivity data and error metric data to determine, such that a loss of productivity metric is reduced, one or both of:

   a number of layers to ramp down in production of integrated circuits prior to the maintenance action on the lithographic apparatus, said layers being lithographically exposed on each of a plurality of substrates using the lithographic apparatus; and/or
   a maintenance schedule metric relating to the frequency of performance of said maintenance action.

2. A method as claimed in claim 1, wherein said productivity data comprises:
   layer cycle time data related to the time required to ramp down production of each layer; and baseline rate parameter data relating to a baseline production rate.

3. A method as claimed in claim 2, wherein said layer cycle time data comprises an average layer cycle time value for each layer.

4. A method as claimed in claim 2, wherein said layer cycle time data comprises a respective layer cycle time value for each layer.

5. A method as claimed in any of claims 2 to 4, wherein the loss of productivity metric comprises a number of substrates lost with respect to said baseline production rate, number of critical substrates lost with respect to said baseline production rate and/or time lost due to said ramp-down and corresponding ramp-up compared to said baseline production rate.

6. A method as claimed in any preceding claim wherein said determining step comprises optimizing a cost function relating the loss of productivity metric to said number of layers to ramp down, productivity data, maintenance schedule metric and error metric data.

7. A method as claimed in claim 6, wherein the cost function comprises a ramp-down term describing the effect of ramping down layers prior to said maintenance action on said loss of productivity metric and a ramp up-term describing the effect of ramping up layers subsequent to said maintenance action on said loss of productivity metric.

8. A method as claimed in any preceding claim comprising obtaining lithographic apparatus monitoring data; and determining said error metric data from said lithographic apparatus monitoring data.

9. A method as claimed in any preceding claim wherein the error metric data is used to determine a number of layers for which a correction loop requires resetting subsequent to said maintenance action.

10. A method as claimed in claim 9, wherein the error metric data comprises correctable error metric data comprising a correctable component of said error metric data.

11. A method as claimed in claim 10, comprising determining the number of layers for which a correction loop requires resetting as all layers which are calculated to cause a jump in said correctable error component which is a above a correctable error threshold indicative of an acceptable magnitude of correctable error.

12. A method as claimed in claim 10 or 11, comprising:

    obtaining lithographic apparatus monitoring data;
    using a conversion model to convert said lithographic apparatus monitoring data into error metric data; and
    determining a correctable component of the error metric data using an actuation model for the lithographic apparatus

13. A method as claimed in any preceding claim, wherein said determining step comprises cooptimizing said number of layers to ramp down and the maintenance schedule metric.

14. A computer program comprising program instructions operable to perform the method of any of claims 1 to 13, when run on a suitable apparatus.

15. A non-transient computer program carrier comprising the computer program of claim 14.

Fig. 1

Fig. 2

(a)                    (b)

Fig. 3

Fig. 4

(a)

(b)

Fig. 5

Fig. 6

Fig. 7

Fig.8

Europäisches
Patentamt

European
Patent Office

Office européen
des brevets

# EUROPEAN SEARCH REPORT

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2021/117931 A1 (ABE KUNIHIKO [JP] ET AL) 22 April 2021 (2021-04-22) | 1,8,14, 15 | INV. G03F7/20 |
| A | * abstract *<br>* figures 7-10,16,17 *<br>* paragraphs [0002], [0209] – [0217], [0233] – [0253], [0294], [0295] * | 2-7,9-13 | G06Q10/00 |
| A | US 2019/129891 A1 (SIGTERMANS DAVID EVERT SONG KOOK [NL] ET AL) 2 May 2019 (2019-05-02)<br>* abstract *<br>* figures 1,2 *<br>* paragraphs [0002], [0006], [0058] – [0064] * | 1-15 | |
| A | DE 10 2018 105322 A1 (ZEISS CARL SMT GMBH [DE]) 12 September 2019 (2019-09-12)<br>* abstract *<br>* figure 4 *<br>* paragraphs [0001] – [0007], [0031] – [0034] * | 1-15 | |

TECHNICAL FIELDS
SEARCHED      (IPC)

G03F
G06Q

The present search report has been drawn up for all claims

| Place of search | Date of completion of the search | Examiner |
|---|---|---|
| Munich | 16 November 2022 | Andersen, Ole |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

............................................................................

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 22 17 4095

This annex lists the patent family members relating to the patent documents cited in the above-mentioned European search report.
The members are as contained in the European Patent Office EDP file on
The European Patent Office is in no way liable for these particulars which are merely given for the purpose of information.

16-11-2022

| Patent document cited in search report | | Publication date | Patent family member(s) | | Publication date |
|---|---|---|---|---|---|
| US 2021117931 | A1 | 22-04-2021 | CN | 112384859 A | 19-02-2021 |
| | | | JP WO2020031301 A1 | | 02-08-2021 |
| | | | US | 2021117931 A1 | 22-04-2021 |
| | | | WO | 2020031301 A1 | 13-02-2020 |
| US 2019129891 | A1 | 02-05-2019 | CN | 109074529 A | 21-12-2018 |
| | | | EP | 3446262 A1 | 27-02-2019 |
| | | | JP | 6664007 B2 | 13-03-2020 |
| | | | JP | 2019519824 A | 11-07-2019 |
| | | | KR | 20180120260 A | 05-11-2018 |
| | | | TW | 201738771 A | 01-11-2017 |
| | | | US | 2019129891 A1 | 02-05-2019 |
| | | | WO | 2017182269 A1 | 26-10-2017 |
| DE 102018105322 A1 | | 12-09-2019 | DE 102018105322 A1 | | 12-09-2019 |
| | | | KR | 20190106754 A | 18-09-2019 |
| | | | TW | 201941164 A | 16-10-2019 |
| | | | US | 2019278187 A1 | 12-09-2019 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2006033921 A1
- US 2010201963 A1
- US 2006066855 A1
- WO 2009078708 A
- WO 2009106279 A
- US 20110027704 A
- US 20110043791 A
- US 2011102753 A1
- US 20120044470 A
- US 20120123581 A
- US 20130258310 A
- US 20130271740 A
- WO 2013178422 A1